Europäisches Patentamt

European Patent Office

Office européen des brevets

(19)

(11) **EP 1 356 592 B1**

(12) **EUROPÄISCHE PATENTSCHRIFT**

(45) Veröffentlichungstag und Bekanntmachung des Hinweises auf die Patenterteilung:
 **01.06.2005 Patentblatt 2005/22**

(21) Anmeldenummer: **02702324.1**

(22) Anmeldetag: **29.01.2002**

(51) Int Cl.$^7$: **H03M 3/02**

(86) Internationale Anmeldenummer:
 **PCT/EP2002/000909**

(87) Internationale Veröffentlichungsnummer:
 **WO 2002/061950 (08.08.2002 Gazette 2002/32)**

(54) **SIGMA-DELTA-MODULATOR ZUR DIGITALISIERUNG VON ANALOGEN HOCHFREQUENZSIGNALEN**

SIGMA-DELTA MODULATOR FOR DIGITIZING ANALOG HIGH FREQUENCY SIGNALS

MODULATEUR SIGMA-DELTA POUR LA NUMERISATION DE SIGNAUX HAUTE FREQUENCE ANALOGIQUES

(84) Benannte Vertragsstaaten:
 **DE FR GB IT**

(30) Priorität: **29.01.2001 DE 10103811**
 **29.01.2001 EP 01101969**

(43) Veröffentlichungstag der Anmeldung:
 **29.10.2003 Patentblatt 2003/44**

(73) Patentinhaber: **Siemens Aktiengesellschaft**
 **80333 München (DE)**

(72) Erfinder: **JELONNEK, Björn**
 **89079 Ulm (DE)**

(56) Entgegenhaltungen:
 **WO-A-00/08765**

**Beschreibung**

Die vorliegende Erfindung betrifft einen Sigma-Delta-Modulator nach dem Oberbegriff des Patentanspruchs 1, sowie ein System und ein Verfahren zur Digitalisierung von analogen Hochfrequenzsignalen mit Hilfe von Sigma-Delta-Modulatoren.

Zur Digitalisierung von Hochfrequenzsignalen existieren im wesentlichen zwei verschiedene Verfahren. Nach dem sogenannten Heterodyn- oder Superheterodyn-Verfahren wird das Hochfrequenzsignal über eine oder mehrere Stufen auf eine tieffrequente Zwischenfrequenz bzw. in das komplexe Basisband (Direct Conversion) umgesetzt. Das hierbei entstehende Signal wird anschliessend durch einen oder - im Falle einer Frequenzumsetzung in das komplexe Basisband - durch zwei konventionelle Analog-Digitalwandler (A/D-Wandler) sowie zusätzliche Mischer in den digitalen Bereich überführt.

Jedoch beeinträchtigen die in diesem Verfahren verwendeten Mischer und Filter durch ihre Nichtlinearitäten die Qualität des analog-digital gewandelten Signals und stellen zum anderen einen erheblichen Kostenfaktor dar. Ferner werden im Fall einer Frequenzumsetzung in das komplexe Basisband Inphase- und Quadraturkomponente realisierungsbedingt mit einem unterschiedlichen Skalierungsfaktor versehen (I/Q-Mismatch), was zu Spiegelfrequenzsignalen im Ausgangsspektrum des A/D-Wandlers führt.

Alternativ lässt sich das analoge Hochfrequenzsignal direkt in ein Digitalsignal umwandeln, beispielsweise mit Hilfe eines Bandpass-Sigma-Delta-A/D-Wandlers. Konzeptionsbedingt tritt bei diesem Verfahren kein I/Q-Mismatch auf. Aufgrund der notwendigen hohen Abtastraten bei HF-Signalen verwenden Bandpass-Sigma-Delta-A/D-Wandler bei ihrem Schwellwertentscheider (Komparator) jedoch nur wenige Signalzustände. Um die Leistung des Quantisierungsfehlers in dem gewünschten Bandpassbereich dennoch gering zu halten, wird das Quantisierungsfehlersignal über einen Digital-Analog-Wandler (D/A-Wandler) sowie ein Bandpassfilter rückgekoppelt und dem Komparator wieder zugeführt . Bei Verwendung von nur zwei Signalzuständen (1 Bit Ausgangssignal) ist theoretisch die Realisierung von A/D-Wandlern sehr hoher Linearität möglich. Eine Darstellung bestehender Sigma-Delta-Modulatoren wird in "Delta-Sigma Data Converters, Theory, Design and Simuiation" von S.R. Norsworthy, R. Schreier und G. Temes, IEEE Press 1997, ISBN 0-7803-1045-4, gegeben.

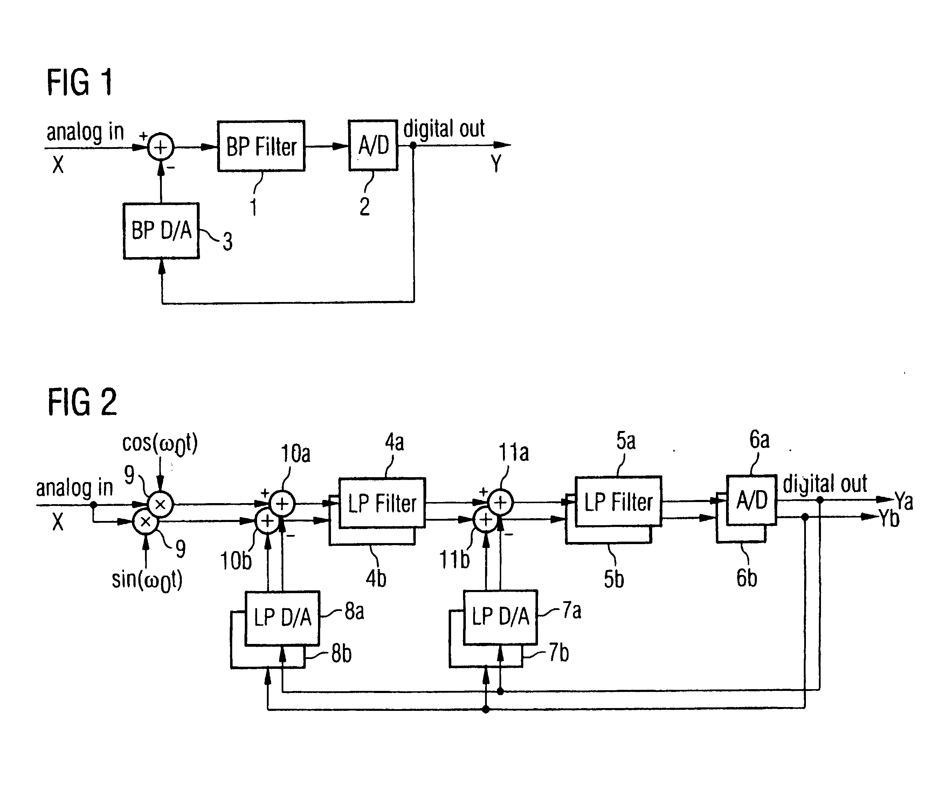

Aufgrund der angestrebten Rauschformung des Quaatisierungsfehlers wird bei den Bandpass-Sigma-Delta-Modulataren häufig eine Filterstruktur zweiter Ordnung verwendet, wie sie in Figur 1 dargestellt ist. Filterstrukturen dritter und höherer Ordnung führen insbesondere wegen der zusätzlich in der Rückkopplungsschleife auftretenden Verzögerungszeiten aufgrund des Komparators und des Bandpass-D/A-Wandlers zu Stabilitätsproblemen des Bandpass-Sigma-Delta-Modulators.

Ferner wird die Stabilität der Bandpass-Sigma-Delta-Modulatoren durch relativ hohe Laufzeitdifferenzen beeinträchtigt, welche in den Bandpassfiltern aufgrund der HF-Signalfrequenzen von mehreren GHz auftreten. Auch lassen sich wegen der erforderlichen hohen Induktivitäten in einer hochintegrierten Schaltung keine Bandpass-Filter hoher Güte realisieren. Die niedrige. Güte der Filter führt zu einem unbefriedigendem Signal-Rauschverhältnis des Bandpass-Sigma-Delta-Modulators im Nutzsignalbereich.

Dokument WO 00/08765 beschreibt in Figur FIG 24. eine Sigma-Delta-Modulator-Anordnung, die einen als Sigma-Delta-Modulator ausgeführten Coarse Quantizer", einen "Primary Feedback DAC" und einen "Main-Delta-Sigma-Modulator" aufweist. Ein analoges Eingangssignal g(t) wird über den "Coarse Quantizer" in ein digitales Ausgangssignal $d_0$(k) umgewandelt, das über den "Primary Feedback DAC" negiert an einen Summier gelangt. Dort wird es auf das analoge Eingangssignal g(t) zur Bildung eines Signals $r_0$(t) aufsummiert und gelangt zur weiteren Verarbeitung an den "Main-Delta-Sigma-Modulator".

Aktive Schaltungen, wie sie beispielsweise in "A Linear Integrated LC-Bandpass Filter with Q-Enhancement", Weinan Gao, W. Martin Snelgrove, IEEE Transactions on Circuits and Systems II: Analog and Digital Processing, Vol. 45, No. 5, May 1998 beschrieben werden, können die Güte des analogen Filters zwar erhöhen, generieren jedoch zusätzliche Nichtlinearitäten, welche sich auf das Signal-Rauschverhältnis des gesamten Bandpass-Sigma-Delta-Modulators auswirken.

Der Einfluss der Filtergüte auf das Signal-Rauschverhältnis des Modulators kann teilweise kompensiert werden, indem zwei oder mehr Bandpass-Sigma-Delta-Modulatoren kaskadiert werden. Hierbei wird das Fehlersignal am Eingang des Komparators der ersten Stufe der Kaskade als Eingangssignal für die zweite Stufe verwendet. Auf diese Weise werden Quantisierungsfehlersignalanteile innerhalb des Nutzbandes noch einmal digitalisiert und der digitalen Auswerteeinheit der zweiten Stufe zugeführt. Jedoch lassen sich derart die Nichtlinearitäten der Bandpass-Filter nicht verbessern.

Aufgabe der Erfindung ist es daher, einen stabilen Sigma-Delta-Modulator mit einem hohen Signal-Rauschverhältnis zu schaffen.

Diese Aufgabe wird gelöst durch einen Sigma-Delta-Modulator zur Digitalisierung eines Hochfrequenz-Eingangssignals mit einem analogen Eingang, einem digitalen Ausgang und einem Rückkoppelzweig zur Unterdrückung von Quantisierungsfehlern, welcher dadurch gekennzeichnet ist, daß er Mittel zur Umwandlung des digitalen Ausgangssignals in ein analoges Signal und Mittel zur Subtraktion des derart umgewandelten Signals von dem analogen Eingangssignal aufweist, wobei das derart erzielte Summensignal an einem analogen Ausgang anliegt. Eine durch die Aufbereitung verursachte zusätzliche Verzögerung des Signals kann nicht zu Stabilitätsproblemen führen, da die Aufbereitung nicht im Rückkoppelzweig des Sigma-Delta-Modulators erfolgt. Da das Signal-Rausch-Verhältnis bei einem erfindungsgemäßen Sigma-Delta-Modulator allein durch das Signal-Rausch-Verhältnis des durch die Mittel zur Umwandlung des digitalen Ausgangssignals in ein analoges Signal, die Mittel zur Aufbereitung des Signals und die Mittel zur Subtraktion des derart umgewandelten Signals von dem analogen Eingangssignals gebildeten direkten Pfades bestimmt wird, können in dem rückgekoppelten übrigen Teil des Sigma-Delta-Modulators Nichtlinearitäten sowie Filter geringer Güte toleriert werden. Insbesondere dieser Teil des Sigma-Delta-Modulators läßt sich daher vorteilhaft als integrierte Schaltung realisieren.

Die Aufgabe wird ferner gelöst durch ein System zur Umwandlung eines analogen Eingangssignals in ein digitales Ausgangssignal mit n Sigma-Delta-Modulatoren (n = 1, 2, 3, ...), welches dadurch gekennzeichnet ist, daß die Sigma-Delta-Modulatoren derart kaskadiert sind, daß das jeweilige analoge Ausgangssignal eines Sigma-Delta-Modulators das Eingangssignal eines folgenden Sigma-Delta-Modulators bildet.

Desweiteren wird die Aufgabe gelöst durch ein Verfahren zur Digitalisierung von analogen Hochfrequenzsignalen mit Hilfe von n Sigma-Delta-Modulatoren, mit folgenden Schritten, welche n-fach (n = 1, 2, ...) von a) bis e) wiederholt werden:

a) Filterung des analogen Eingangssignals,
b) Quantisierung des analogen Eingangssignals mit einer Abtastrate $f_a$, zu Zeitpunkten t = m * $T_a$, wobei m = 0, 1, 2,... und $T_a$ die Abtastperiode eines Sigma-Delta-Modulators ist, und Ausgabe des quantisierten Signals,
c) Umwandlung des quantisierten Signals in ein analoges Signal,
d) Subtraktion des umgewandelten analogen Signals von dem analogen Eingangssignal des Sigma-Delta-Modulators derselben Verfahrensstufe,
e) Verwendung des summierten Signals als analoges Eingangssignal des Sigma-Delta-Modulators der folgenden Verfahrensstufe,

und - Auswertung der n quantisierten Signale der n Verfahrensstufen.

Gemäß einer vorteilhaften Ausgestaltung des Sigma-Delta-Modulators weist dieser Mittel auf, durch die Amplitude, Frequenz und/oder Phasenlage des analogen Eingangssignals veränderbar sind, so daß Anpassungen des analogen Eingangssignals an das von diesem subtrahierte umgewandelte analoge Signal möglich sind.

Vorteilhaft weist der Sigma-Delta-Modulator Bandpässe zur Frequenzumsetzung des Hochfrequenz-Eingangssignals auf.

Gemäß einer weiteren Ausgestaltung weist der Sigma-Delta-Modulator Mischer zur Aufspaltung des Eingangssignals in eine Inphase- und eine Quadraturkomponente sowie Tiefpässe zur Umsetzung der Inphase- und der Quadraturkomponente des Hochfrequenz-Eingangssignals in niederfrequentere Signale auf.

Bevorzugt weist das System eine Einheit zur Auswertung der n digitalen Ausgangssignale der n Sigma-Delta-Modulatoren auf.

Vorteilhafte Ausgestaltungen des erfindungsgemässen Sigma-Delta-Modulators, des Systems mit n Sigma-Delta-Modulatoren und des Verfahren sind Gegenstand weiterer Unteransprüche.

Die Erfindung wird nun anhand der beigefügten Zeichnung im Einzelnen beschrieben. Hierbei zeigen

Figur 1    ein Blockschaltbild eines Bandpass-Sigma-Delta-Modulators erster Ordnung gemäß dem Stand der Technik,

Figur 2    ein Blockschaltbild eines Tiefpass-Sigma-Delta-Modulators zweiter Ordnung gemäß dem Stand der Technik,

Figur 3    ein Blockschaltbild eines zweistufig kaskadierten Bandpass-Sigma-Delta-Modulators zweiter Ordnung gemäß dem Stand der Technik,

Figur 4    ein Blockschaltbild eines erfindungsgemässen Sigma-Delta-Modulators,

Figur 5    ein Blockschaltbild einer weiteren Ausführungsform eines erfindungsgemäßen Sigma-Delta-Modulators, und

Figur 6    ein Blockschaltbild der Gesamtstruktur eines erfindungsgemässen Systems mit drei Sigma-Delta-Modulatoren.

In Figur 1 ist die Grundstruktur eines Bandpass-Sigma-Delta-Modulators erster Ordnung dargestellt. Das analoge Eingangssignal X wird über ein Bandpass-Filter 1 zu einem Analog-Digital-Wandler 2 geführt. Das digitale Ausgangssignal des Analog-Digital-Wandlers 2 wird anschließend über eine Rückkopplungsschleife, welche einen Bandpass-Digital-Analog-Wandler 3 aufweist, zum Eingang zurückgeführt und von dem Eingangssignal X subtrahiert.

Ein Tiefpass-Sigma-Delta-Modulator zweiter Ordnung, wie aus dem Stand der Technik bekannt, wird in Figur 2 dargestellt. Das analoge Eingangssignal X wird in einem Mischer 9 mittels Multiplikation mit einem cos- bzw. einem sin-Signal in eine Inphase- und eine Quadratur-Komponente aufgespalten (Direct Conversion). Jede Komponente wird jeweils über zwei Tiefpässe 4a bzw. 4b und 5a bzw. 5b gefiltert und anschließend in einem Analog-Digital-Wandler 6a bzw. 6b abgetastet. Das digitale Ausgangssignal Ya bzw. Yb wird in zwei Rückkopplungsschleifen über Tiefpass-Digital-Analog-Wandler 7a bzw. 7b und 8a bzw. 8b den Summierern 10a bzw. 10b zugeführt und jeweils von dem analogen Signal subtrahiert. Die Zusammenführung der beiden digitalen Ausgangssignale Ya und Yb erfolgt in einer (nicht dargestellten) Auswerteeinheit.

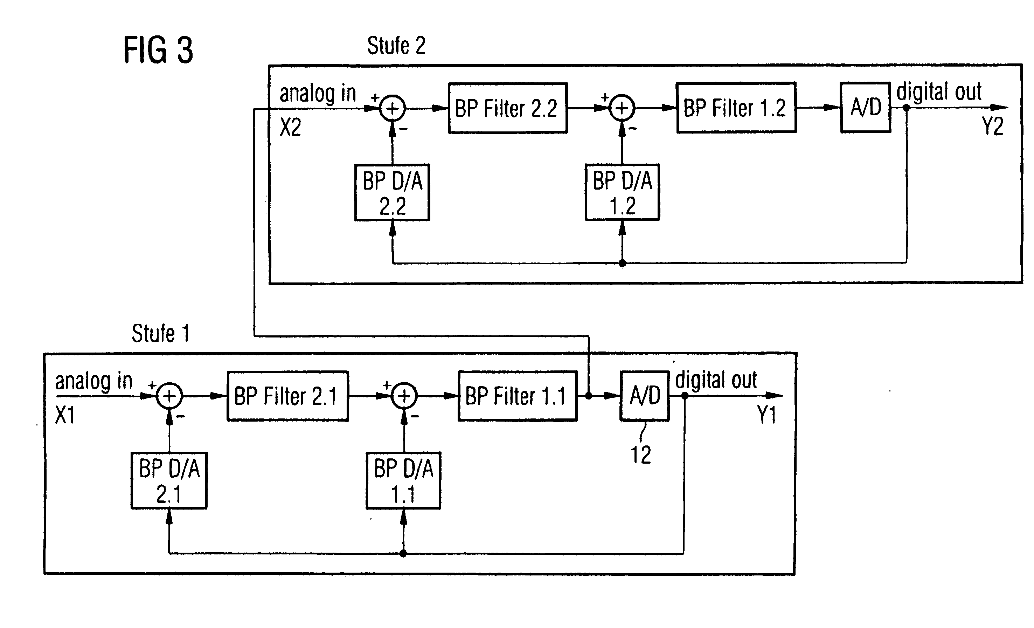

Figur 3 zeigt einen Bandpass-Sigma-Delta-Modulator zweiter Ordnung gemäß dem Stand der Technik, welcher als zweistufige Kaskade aufgebaut ist. Das Eingangssignal des Analog-Digital-Wandlers 12 der ersten Stufe der Kaskade bildet hierbei das Eingangssignal X2 der zweiten Stufe der Kaskade.

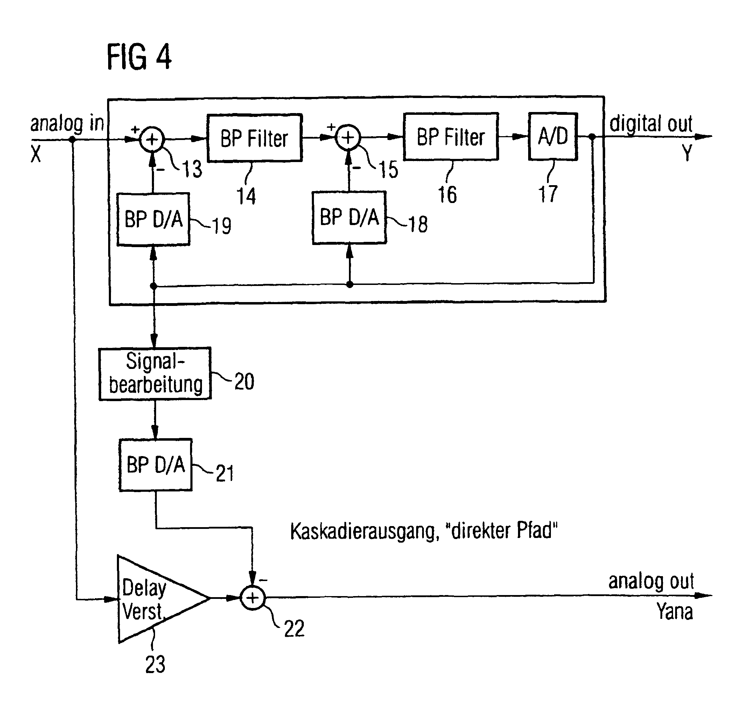

In Figur 4 ist ein erfindungsgemäßer einstufiger Bandpass-Sigma-Delta-Modulator dargestellt. Das analoge Eingangssignal X wird über einen Summierer 13 einem ersten Bandpass 14 zugeführt und das gefilterte Signal wird über einen weiteren Summierer 15 geführt und erneut in einem Bandpass 16 gefiltert. Anschließend wird das analoge Signal in einem Analog-Digital-Wandler 17 quantisiert. Das derart erzeugte digitale Signal bildet einerseits das digitale Ausgangssignal Y des Sigma-Delta-Modulators und wird andererseits über jeweils einen Bandpass-Digital-Analog-Wandler 18 bzw. 19 analogisiert und mit negativem Vorzeichen den Summierern 13 bzw. 15 zugeführt.

Das digitale Ausgangssignal Y kann über einen sogenannten "direkten" Pfad einer Signalbearbeitung 20 zugeführt werden. Anschließend wird das Signal in einem weiteren Bandpass-Digital-Analog-Wandler 21 umgewandelt und mit negativem Vorzeichen einem Summierer 22 zugeführt. Als Beispiel für eine mögliche Signalbearbeitung des Signals kann eine Abtastratenerhöhung genannt werden, welche dazu führt, dass der Bandpass-Digital-Analog-Wandler 21 mit einer gegenüber den Bandpass-Digital-Analog-Wandlern 14 und 16 erhöhten Taktfrequenz arbeitet. Der Vorteil einer derartigen ,Bearbeitung liegt in der Erhöhung der Leistung einer Oberwelle des Bandpass-Digital-Analog-Wandler 11, welches den Leistungsverbrauch des Gesamtsystems im Oberwellenbetrieb reduziert.

Eine weitere Möglichkeit der Signalbearbeitung des digitalen Ausgangssignals Y im "direkten" Pfad ist der Einsatz einer digitalen Amplituden- oder Phasenkorrektur. Bei dieser digitalen Berechnung werden mehrere, gegeneinander zeitverzögerte Signale gewichtet miteinander addiert. Hierdurch erhöht sich die Anzahl der Quantisierungsstufen des digital nachbehandelte Signals gegenüber der Anzahl der Quantisierungsstufen des Ausgangssignals Y. Mit Hilfe eines zusätzlichen digital realisierten Sigma-Delta-Modulators kann dieses mehrstufige Signal wieder in der Stufenanzahl reduziert werden.

Wie aus Figur 4 ersichtlich, wird das analoge Eingangssignal X ebenfalls dem Summierer 22 zugeführt. Das resultierende Signal bildet das analoge Ausgangssignal $Y_{ana}$ des Sigma-Delta-Modulators, welches zusammen mit dem digitalen Ausgangssignal Y einer (hier nicht dargestellten) Auswerteeinheit zugeführt wird. Das analoge Signal X wird, bevor es zu dem Summierer 22 gelangt, vorteilhaft über einen Verstärker 23 geführt, der mit einem Verzögerer kombiniert sein kann. Auf diese Weise können die Eingangsamplituden und die Phasenlage der zu dem Summierer 22 geführten Signale angeglichen werden. Am Eingang des Bandpass-Digital-Analog-Wandlers 21 kann ferner eine Möglichkeit zur Phasenkorrektur des Signals vorgesehen sein.

Da der Bandpass-Digital-Analog-Wandler 21 sich erfindungsgemäß nicht im rückgekoppelten Zweig des Sigma-Delta-Modulators befindet und somit keine Auswirkungen auf die Stabilität des Regelkreises hat, braucht keine Rücksicht auf die durch ihn verursachten Verzögerungszeiten genommen zu werden.

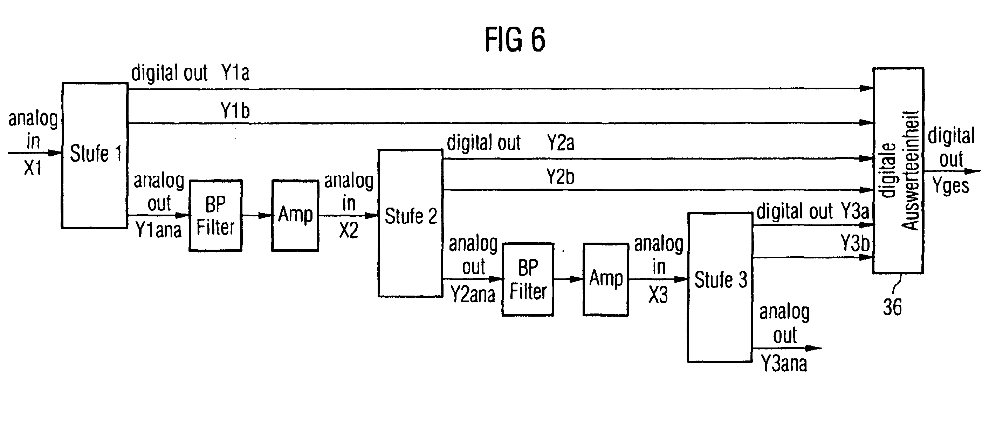

Das Signal-Rauschverhältnis des erfindungsgemäßen Sigma-Delta-Modulators wird allein durch das Signal-Rausch-Verhältnis des "direkten" Pfades, bestehend aus Signalbearbeitung 20 und Bandpass-Digital-Analog-Wandler 21, bestimmt. Der Grund hierfür ist folgender: Durch Nichtidealitäten des Analog-Digital-Wandlers 17 hervorgerufene Verzerrungen treten sowohl im "direkten" Pfad wie auch im digitalen Ausgangssignal Y auf. Das Signal des direkten Pfades wird durch den Analog-Digital-Wandler des in der Kaskade nachfolgenden Sigma-Delta-Wandlers gemessen und einer nachfolgenden digitalen Auswerteeinheit (siehe Figur 6) zur Verfügung gestellt. In dieser kann durch einfache Vorentzerrung und Linearkombination der Signale die Verzerrung rechnerisch bestimmt und entfernt werden. Daher können im rückgekoppelten Teil des Sigma-Delta-Modulators in einem erhöhten Maße Nichtlinearitäten der Bauteile, insbesondere der Filter, toleriert werden. Im folgenden wird dieser Sachverhalt näher erläutert:

Es soll ein möglichst exakte Analog/Digital-Wandlung des analogen Signals X vorgenommen werden. Es wird angenommen, dass bei den Mischern bzw. den A/D-Wandlern Störungen auftreten, die sich auf das digitale Ausgangssignal auswirken. Alle einzelnen Störungen seien in einem gemeinsamen Fehlersignal $E_{AD}$ zusammengefaßt, so dass für das digitale Ausgangssignal Y gilt:

$$Y = X + E_{AD}$$

Durch die Bandpaß-D/A-Wandlung im direkten Pfad treten in erster Näherung nur lineare Verzerrungen des digitalen Ausgangssignals. auf, die in dem betrachteten Band sehr gut mit einer einfachen Signalskalierung verglichen werden können. Die verbleibenden nichtlinearen Verzerrungen werden für diese Betrachtung in dem Fehlersignal $E_{BPAD}$ zusammengefaßt.

$$Y_{ana} = H_{BPDA} \, Y + E_{BPDA}$$

Dieses Signal wird erfindungsgemäß von dem analogen Signal X subtrahiert und als analoges Kaskadiersignal über ein Filter (Übertragungsfunktion $H_{ana}$) sowie einen Verstärker (Verstärkung V)dem A/D-Wandler der nächsten Kaskade zugeführt.

$$X_2 = H_{ana}V(X - Y_{ana})$$

Auch dieser zweite A/D-Wandler ist nicht optimal:

$$Y_2 = X_2 + E_{AD_2}$$

Im einfachsten Fall einer zweistufigen Kaskade liegen also der digitalen Auswerteeinheit die Signale Y und $Y_2$ vor.

$$Y_2 = H_{ana}V(X - Y_{ana}) + E_{AD_2}$$

$$= H_{ana}V(X - H_{BPDA}Y - E_{BPDA}) + E_{AD_2}$$

$$= H_{ana}V(X - H_{BPDA}Y - E_{BPDA}) + E_{AD_2}$$

$$= H_{ana}V(X - H_{BPDA}(X + E_{AD}) - E_{BPDA}) + E_{AD_2}$$

$$= H_{ana}V((1 - H_{BPDA})X + H_{BPDA}E_{AD} - E_{BPDA}) + E_{AD_2}$$

Es wird durch schaltungstechnische Maßnahmen angestrebt, dass in dem betrachteten Frequenzband

$$H_{BPDA} \approx 1$$

gilt. Damit erhält man

$$Y_2 \approx H_{ana}V(E_{AD} - E_{BPDA}) + E_{AD_2}$$

Wegen des gleichartigen Aufbaus der kaskadierten A/D-Wandler ist die Leistung des durch diese Wandler eingebrachten Fehlers als in der gleichen Größenordnung anzunehmen, während die Leistung des Fehlersignals der Bandpass-D/A-Wandler sehr viel geringer ist. Da für den Verstärkungsfaktors $H_{ana}V \gg 1$ gilt, vereinfacht sich die Darstellung für $Y_2$ weiter:

$$Y_2 \approx H_{ana}VE_{AD}$$

Bis auf einen unbekannten Frequenzgang des analogen Filters - das nur bei einer geringen Anzahl von Quantisierungsstufen zwingend notwendig ist - mißt man mit dem Kaskadierausgang den durch den ersten A/D-Wandler eingebrachten Fehler.

Dieser Idealfall gilt nur dann, wenn der Fehlereinfluß des direkten Pfades vernachlässigt werden kann. Ist dies nicht der Fall, so erhält man

$$Y_2 \approx H_{ana}V(E_{AD} - E_{BPDA})$$

Man kann in $Y_2$ nicht zwischen Fehler des A/D-Wandlers und des Bandpass-D/A-Wandlers unterscheiden und den Fehler in Y deshalb auch nur mit der Güte des BP-D/A-Wandlers (des direkten Pfades) realisieren.

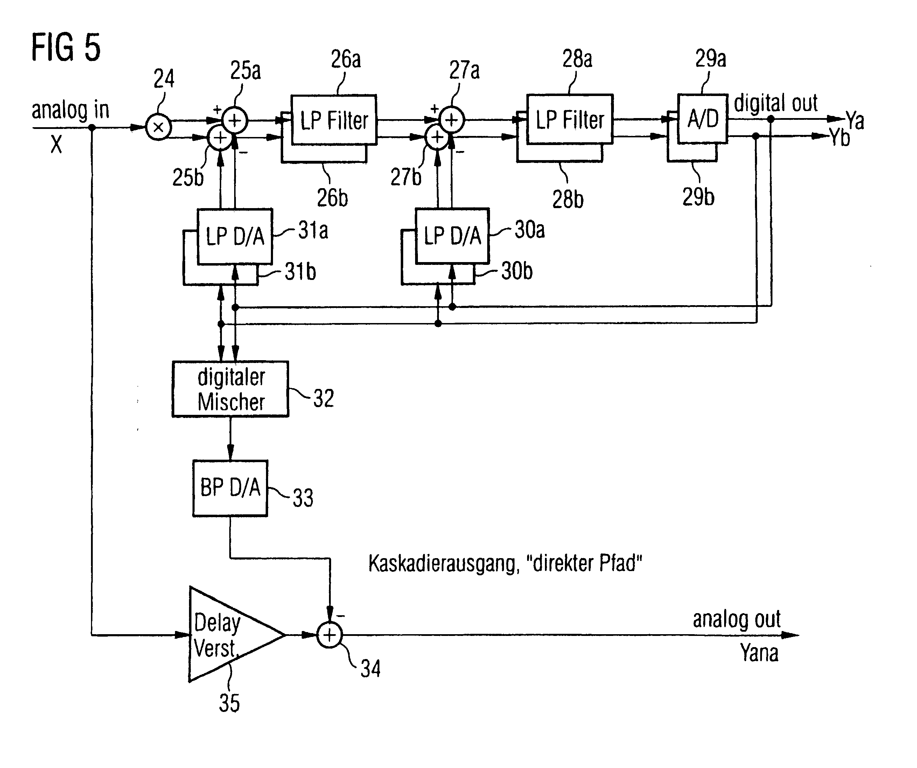

Gemäß einer weiteren Ausführungsform der Erfindung können in dem rückgekoppelten Teil des Sigma-Delta-Modulators anstelle der Bandpässe Tiefpässe verwendet. werden. Diese Ausführungsform ist in Figur 5 dargestellt. Hierzu wird das analoge Eingangssignal X mit Hilfe eines Mischers 24, in dem eine Multiplikation des Signals mit jeweils einem cos- und einem sin-Signal erfolgt, in eine Inphase- und eine Quadratur-Komponente aufgespalten und in das komplexe Basisband umgesetzt (Direct Conversion). Beide Signalkomponenten werden parallel verarbeitet und jeweils durch Tiefpässe 26a bzw. 26b und 28a bzw. 28b gefiltert und anschließend in einem Analog-Digital-Wandler 29a bzw. 29b quantisiert. Auch die Rückführung der digitalen Signale Ya bzw. Yb erfolgt in zwei parallelen Rückkopplungszweigen mit Tiefpass-Digital-Analog-Wandlern 30a bzw. 30b und 31a bzw. 31b. Durch die Umsetzung des HF-Eingangssignals X in das komplexe Basisband können frequenzunabhängige Digital-Analog-Wandler 30a bzw. 30b und 31a bzw. 31b eingesetzt werden. In den "direkten" Pfad wird zusätzlich ein digitaler Mischer 32 aufgenommen, welcher neben der Zusammenführung der Inphaseund der Quadraturkomponente des Signals auch eine weitere Signalbearbeitung wie bereits unter Figur 4 beschrieben, durchführen kann. Anschließend wird das Signal, wie beschrieben weiterverarbeitet.

Ermöglicht wird die erfindungsgemäße Ausführungsform mit direkter Umsetzung des Signals in das komplexe Basisband durch die herabgesetzten Anforderungen an die Linearität der Bauteile im rückgekoppelten Teil des Sigma-Delta-Modulators. Fehlersignale, welche durch das Rauschen des Mischers 32, die durch ihn eingebrachten Nichtlinearitäten sowie einen I/Q-Mismatch hervorgerufen werden, finden sich sowohl in dem digitalen als auch in dem analogen Ausgangssignal Y bzw. $Y_{ana}$ wieder, so daß der Fehler durch geeignete Verfahren bestimmt und behoben werden kann.

Figur 6 zeigt die Gesamtstruktur eines erfindungsgemäßen dreistufig kaskadierten Systems von Sigma-Delta-Modulatoren mit direkter Umsetzung in das komplexe Basisband. Hierzu werden drei Sigma-Delta-Modulatoren derart kaskadiert, daß das jeweilige analoge Ausgangssignal Yl$_{ana}$ (Y2$_{ana}$ , Y3$_{ana}$) einer Stufe des Sigma-Delta-Modulators das analoge Eingangssignal X1 (X2, X3) der folgenden Stufe des Sigma-Delta-Modulators bildet. Von jeder Stufe des Systems werden jeweils die Inphase- und die Quadraturkomponente als zwei digitale Ausgangssignale Y1a, Y1b (Y2a, Y2b, Y3a, Y3b) einer digitalen Auswerteeinheit 36 zugeführt, welche aus der Gesamtheit der digitalen Eingangssignale (Y1a, Y1b, Y2a, Y2b, Y3a, Y3b) das digitale Ausgangssignal $Y_{ges}$ bestimmt. Die mehrfache Kaskadierung des Sigma-Delta-Modulators ermöglicht eine genaue Bestimmung der Ausgangssignale des direkten Pfades jeder Stufe und somit der Nichtlinearitäten der Analog-Digital-Wandler aller Stufen der Kaskade mit Ausnahme der letzten. Da nur an der ersten Stufe das Eingangssignal gemessen wird, ist der hier auftretende Fehler von besonderer Bedeutung.

**Patentansprüche**

1.  Sigma-Delta-Modulator zur Umwandlung eines analogen hochfrequenten Eingangssignals (X) in ein digitales Ausgangssignal (Ya,Yb),

    -   bestehend aus einem Mischer (24), der das analoge Eingangssignal (X) in eine Inphase-Komponente und in eine Quadratur-Komponente aufteilt,
    -   bestehend aus einer ersten und aus einer zweiten Anordnung zur Generierung eines die Inphase-Komponente bzw. die Quadratur-Komponente repräsentierenden Ausgangssignals (Ya, Yb),
    -   wobei jede Anordnung jeweils zwei Summierer (25a, 25b, 27a, 27b), zwei Tiefpässe (26a, 26b, 28a, 28b), einen Analog-Digital-Wandler (29a, 29b) und zwei Tiefpass-Digital-Analog-Wandler (31a, 31b, 30a, 30b) beinhaltet, die derart miteinander verbunden sind,
    -   dass ein an einem ersten Summierer (25a,25b) anliegendes Eingangssignal über einen ersten Tiefpass (26a, 26b) an einen dem ersten Tiefpass nachgeschalteten zweiten Summierer (27a, 27b) angeschaltet ist,
    -   dass ein vom zweiten Summierer (27a, 27b) gebildetes Signal über einen zweiten Tiefpass (28a, 28b) an den Analog-Digital-Wandler (29a, 29b) geschaltet ist,
    -   dass bei der ersten Anordnung die Inphase-Komponente und bei der zweiten Anordnung die Quadratur-Komponente als Eingangssignal an den jeweiligen ersten Tiefpass (26a, 26b) angeschaltet ist,
    -   dass zur Unterdrückung von Quantisierungsfehlern bei der ersten Anordnung ein die Inphase-Komponente repräsentierendes digitales Ausgangssignal (Ya) des Analog-Digital-Wandlers (29a) einerseits über einen ersten Tiefpass-Digital-Analog-Wandler (31a) negiert an den ersten Summierer (25a) und andererseits über einen zweiten Tiefpass-Digital-Analog-Wandler (30a) negiert an den zweiten Summierer (27a) geschaltet ist, und
    -   dass zur Unterdrückung von Quantisierungsfehlern bei der zweiten Anordnung ein die Quadratur-Komponente repräsentierendes digitales Ausgangssignal (Yb) des Analog-Digital-Wandlers (29b) einerseits über einen ersten Tiefpass-Digital-Analog-Wandler (31b) negiert an den ersten Summierer (25b) und andererseits über einen zweiten Tiefpass-Digital-Analog-Wandler (30b) negiert an den zweiten Summierer (27b) geschaltet ist,

    **dadurch gekennzeichnet, dass**

    -   die beiden digitalen Ausgangssignale (Ya, Yb) über einen digitalen Mischer (32) an einen gemeinsamen Bandpass-Digital-Analog-Wandler (33) zur Bildung eines analogen Ausgangssignals geschaltet sind, und
    -   dass das analoge Eingangssignal (X) des Sigma-Delta-Modulators laufzeitverzögert zusammen mit dem negierten analogen Ausgangssignal des gemeinsamen Bandpass-Digital-Analog-Wandlers (33) an einen Summierer (34) zur Bildung eines analogen Subtraktionssignals (Yana) geschaltet ist.

2.  Sigma-Delta-Modulator nach Anspruch 1, **dadurch gekennzeichnet, dass** das analoge Eingangsignal (X) des Sigma-Delta-Modulators über einen Delay-Verstärker (35) zur Laufzeitverzögerung an den Summierer (34) zur Bildung des analogen Subtraktionssignals (Yana) angeschaltet ist.

3.  System zur Umwandlung eines analogen Eingangssignals (X) in ein digitales Ausgangssignal (Y1a,Y1b,Y2a,Y2b,Y3a,Y3b) mit n Sigma-Delta-Modulatoren nach einem der vorhergehenden Ansprüche, **dadurch gekennzeichnet, dass** die n Sigma-Delta-Modulatoren derart kaskadiert zueinander angeordnet sind, dass das jeweilige analoge Subtraktionssignal (Y1ana,Y2ana) eines n-1 ten Sigma-Delta-Modulators (Stufe1,Stufe2) das analoge Eingangssignal (X2,X3) eines n-ten Sigma-Delta-Modulators (Stufe2,Stufe3) bildet.

4.  System nach Anspruch 3, **dadurch gekennzeichnet, dass** das System eine digitale Auswerteeinheit (36) zur Auswertung von 2n digitalen jeweils eine Inphase-Komponente bzw. eine Quadratur-Komponente repräsentierenden Ausgangssignale der n Sigma-Delta-Modulatoren aufweist.

5.  Verfahren zur Digitalisierung von analogen Hochfrequenzsignalen mit Hilfe eines Systems mit kaskadierten n Sigma-Delta-Modulatoren nach Anspruch 3 oder 4, **dadurch gekennzeichnet, dass** folgende Schritte n-fach wiederholt werden:

- Filterung des analogen Eingangssignals,
- Quantisierung des analogen Eingangssignals mit einer Abtastrate $f_a$, zu Zeitpunkten $t = m^* T_a$, mit $m = 0, 1, 2,...$ und mit $T_a$ als Abtastperiode eines Sigma-Delta-Modulators
- Ausgabe des quantisierten Signals als digitales Ausgangssignal an die digitale Auswerteeinheit (36),
- Digitale Mischung und Umwandlung (32,33) des quantisierten Signals in ein analoges Signal,
- Subtraktion (34) des umgewandelten analogen Signals von dem laufzeitverzögerten analogen Eingangssignal des Sigma-Delta-Modulators derselben Verfahrensstufe zur Bildung eines Subtraktionssignals,
- Verwendung des Subtraktionssignals als analoges Eingangssignal des Sigma-Delta-Modulators der folgenden Verfahrensstufe, und
- abschließende Auswertung der digitalen Ausgangssignale der n Verfahrensstufen mit Hilfe der digitalen Auswerteeinheit (36).

6. Verfahren zur Digitalisierung von analogen Hochfrequenzsignalen nach Anspruch 5, **dadurch gekennzeichnet, dass** das Subtraktionssignal einer Verfahrensstufe eine Signalbearbeitung (BP filter, Amp) erfährt.

7. Verfahren zur Digitalisierung von analogen Hochfrequenzsignalen nach Anspruch 5 oder 6, **dadurch gekennzeichnet, dass** das Subtraktionssignal einer n-1 ten Verfahrensstufe als quantisiertes analoges Eingangssignal einer n-ten Verfahrensstufe mit einer gegenüber der Abtastrate $f_a$ erhöhten Abtastrate $f_{erh}$ abgetastet wird.

8. Verfahren zur Digitalisierung von analogen Hochfrequenzsignalen nach Anspruch 6 oder 7, **dadurch gekennzeichnet, dass** das Subtraktionssignal eine Amplituden- und/oder Phasenkorrektur erfährt.

## Claims

1. Sigma-delta modulator for converting an analogue high-frequency input signal (X) to a digital output signal (Ya, Yb)

- comprising a mixer (24), which splits the analogue input signal (X) into a in-phase component and a quadrature component,
- comprising a first and a second arrangement for generating an output signal (Ya, Yb) representing the in-phase component or the quadrature component,

- each arrangement respectively containing two summing units (25a, 25b, 27a, 27b), two low passes (26a, 26b, 28a, 28b), an analogue/digital converter (29a, 29b) and two low-pass digital/analogue converters (31a, 31b, 30a, 30b), which are connected together such that
- an input signal present at a first summing unit (25a, 25b) is switched via a first low pass (26a, 26b) to a second summing unit (27a, 27b) connected downstream of the first low pass,
- a signal formed by the second summing unit (27a, 27b) is switched via a second low pass (28a, 28b) to the analogue-digital converter (29a, 29b),
- in the case of the first arrangement the in-phase component and in the case of the second arrangement the quadrature component is switched as the input signal to the respective first low pass (26a, 26b),
- to suppress quantisation errors in the case of the first arrangement a digital output signal (Ya) of the analogue-digital converter (29a) representing the in-phase component is switched on the one hand in a negated manner via a first low-pass digital/analogue converter (31a) to the first summing unit (25a) and on the other hand in a negated manner via a second low-pass digital/analogue converter (30a) to the second summing unit (27a), and
- to suppress quantisation errors in the case of the second arrangement a digital output signal (Yb) of the analogue/digital converter (29b) representing the quadrature component is switched on the one hand in a negated manner via a first low-pass digital/analogue converter (31b) to the first summing unit (25b) and on the other hand in a negated manner via a second low-pass digital/analogue converter (30b) to the second summing unit (27b),

**characterised in that**

- the two digital output signals (Ya, Yb) are switched via a digital mixer (32) to a common bandpass digital/analogue converter (33) to form an analogue output signal and
- the analogue input signal (X) of the sigma-delta modulator is switched with a propagation delay together with the negated analogue output signal of the common bandpass digital/analogue converter (33) to a summing unit (34) to form an analogue subtraction signal (Yana).

2. Sigma-delta modulator according to Claim 1, **characterized in that** the analogue input signal (X) of the sigma-delta modulator is switched via a delay amplifier (35) for delaying propagation to the summing unit (34) to form the analogue subtraction signal (Yana).

**3.** System for converting an analogue input signal (X) to a digital output signal (Yla, Y1b, Y2a, Y2b, Y3a, Y3b) with n sigma-delta modulators according to one of the preceding Claims, **characterized in that** the n sigma-delta modulators are arranged in relation to one another cascaded such that the respective analogue subtraction signal (Ylana, Y2ana) of an n-lth sigma-delta modulator (Stagel, Stage2) forms the analogue input signal (X2, X3) of an nth sigma-delta modulator (Stagel, Stage2).

**4.** System according to Claim 3, **characterized in that** the system has a digital evaluation unit (36) for evaluating 2n digital output signals of the n sigma-delta modulators representing an in-phase component or a quadrature component respectively.

**5.** Method for digitising analogue high-frequency signals using a system with cascaded n sigma-delta modulators according to Claim 3 or 4, **characterised in that** the following steps are repeated n times:

- filtering the analogue input signal,
- quantising the analogue input signal with a scanning rate $f_a$, at times t = m $^*$ $T_a$, with m = 0, 1, 2, ... and with $T_a$ as the scanning period of a sigma-delta modulator
- outputting the quantised signal as the digital output signal to the digital evaluation unit (36),
- digitally mixing and converting (32, 33) the quantised signal to an analogue signal,
- subtracting (34) the converted analogue signal from the propagation-delayed input signal of the sigma-delta modulator of the same method stage to form a subtraction signal,
- using the subtraction signal as the analogue input signal of the sigma-delta modulator of the next method stage, and
- finally evaluating the digital output signals of the n method stages using the digital evaluation unit (36).

**6.** Method for digitising analogue high-frequency signals according to Claim 5, **characterized in that** the subtraction signal of one method stage is subject to signal processing (BP filter, Amp).

**7.** Method for digitising analogue high-frequency signals according to Claim 5 or 6, **characterized in that** the subtraction signal of an n-lth method stage is scanned as the quantised analogue input signal at a scanning rate $f_{erh}$ that is higher than the scanning rate $f_a$.

**8.** Method for digitising analogue high-frequency signals according to Claim 6 or 7, **characterized in that** the subtraction signal is subject to amplitude or phase correction.

## Revendications

**1.** Modulateur sigma-delta pour la conversion d'un signal d'entrée haute fréquence analogique (X) en un signal de sortie numérique (Ya, Yb),

- comprenant un mélangeur (24) qui divise le signal d'entrée analogique (X) en une composante en phase et une composante en quadrature,
- comprenant un premier et un second dispositifs pour générer un signal de sortie (Ya, Yb) représentant la composante en phase resp. la composante en quadrature,
- chaque dispositif comprenant à chaque fois deux additionneurs (25a, 25b, 27a, 27b), deux filtres passe-bas (26a, 26b, 28a, 28b), un convertisseur analogique-numérique (29a, 29b) et deux convertisseurs numérique-analogique à filtre passe-bas (31a, 31 b, 30a, 30b), qui sont reliés les uns aux autres de manière
- à ce qu'un signal d'entrée appliqué à un premier additionneur (25a, 25b) soit branché, par le biais d'un premier filtre passe-bas (26a, 26b), sur un second additionneur (27a, 27b) monté derrière le premier filtre passe-bas,
- à ce qu'un signal formé par le second additionneur (27a, 27b) soit branché sur le convertisseur analogique-numérique (29a, 29b) par le biais d'un second filtre passe-bas (28a, 28b),
- à ce que, dans le premier dispositif, la composante en phase soit branchée, et dans le second dispositif, la composante en quadrature soit branchée, en tant que signal d'entrée sur le premier filtre passe-bas respectif (26a, 26b),
- à ce que, pour supprimer les erreurs de quantification dans le premier dispositif, un signal de sortie numérique (Ya) du convertisseur analogique-numérique (29a) représentant la composante en phase soit, d'une part, branché avec un signe négatif sur le premier additionneur (25a) par le biais d'un premier convertisseur numérique-analogique à filtre passe-bas (31a) et, d'autre part, branché avec un signe négatif sur le second additionneur (27a) par le biais d'un second convertisseur numérique-analogique à filtre passe-bas (30a) et
- à ce que, pour supprimer les erreurs de quantification dans le second dispositif, un signal de sortie numérique (Yb) du convertisseur analogique-numérique (29b) représentant la composante en quadrature soit, d'une part, branché avec un signe négatif sur le premier additionneur (25b) par le biais d'un premier convertisseur numérique-analogique à filtre passe-bas (31 b) et, d'autre part, branché avec un signe négatif sur le second additionneur (27b) par le biais d'un second convertisseur numérique-analogique à filtre passe-bas (30b),

**caractérisé en ce que**

- les deux signaux de sortie numériques (Ya, Yb) sont branchés par le biais d'un mélangeur numérique (32) sur un convertisseur numérique-analogique à filtre passe-bande commun (33) pour former un signal de sortie analogique et
- **en ce que** le signal d'entrée analogique (X) du modulateur sigma-delta est branché avec un retard du temps de propagation sur un additionneur (34), avec le signal de sortie analogique pourvu du signe négatif du convertisseur numérique-analogique à filtre passe-bande commun (33), pour former un signal de soustraction analogique (Yana).

2. Modulateur sigma-delta selon la revendication 1, **caractérisé en ce que** le signal d'entrée analogique (X) du modulateur sigma-delta est branché sur l'additionneur (34) par le biais d'un amplificateur-temporisateur (35) servant à introduire un retard du temps de propagation, pour former le signal de soustraction analogique (Yana).

3. Système pour la conversion d'un signal d'entrée analogique (X) en un signal de sortie numérique (Y1a, Y1b, Y2a, Y2b, Y3a, Y3b), comprenant n modulateurs sigma-delta selon l'une des revendications précédentes,
**caractérisé en ce que**
les n modulateurs sigma-delta sont montés en cascade les uns par rapport aux autres de manière à ce que le signal de soustraction analogique respectif (Y1ana, Y2ana) d'un n-1$^{ème}$ modulateur sigma-delta (étage 1, étage 2) forme le signal d'entrée analogique (X2, X3) d'un n$^{ème}$ modulateur sigma-delta (étage 2, étage 3).

4. Système selon la revendication 3, **caractérisé en ce que** le système comprend une unité d'analyse numérique (36) pour l'analyse de 2n signaux de sortie numériques des n modulateurs sigma-delta représentant à chaque fois une composante en phase resp. une composante en quadrature.

5. Procédé de numérisation de signaux haute fréquence analogiques à l'aide d'un système comprenant n modulateurs sigma-delta en cascade selon la revendication 3 ou 4, **caractérisé en ce que** les étapes suivantes sont répétées n fois :

- filtrage du signal d'entrée analogique
- quantification du signal d'entrée analogique avec une vitesse de balayage $f_a$ aux instants t = m $^*$ $T_a$, avec m = 0, 1, 2, ... et avec $T_a$ en tant que période de balayage d'un modulateur sigma-delta,
- sortie du signal quantifié en tant que signal de sortie numérique à l'unité d'analyse numérique (36),
- mélange numérique et conversion (32, 33) du signal quantifié en un signal analogique,
- soustraction (34) du signal analogique converti du signal d'entrée analogique retardé par le temps de propagation du modulateur sigma-delta du même étage de procédé pour former un signal de soustraction,
- utilisation du signal de soustraction en tant que signal d'entrée analogique du modulateur sigma-delta de l'étage de procédé suivant, et
- analyse finale des signaux de sortie numériques des n étages de procédé à l'aide de l'unité d'analyse numérique (36).

6. Procédé de numérisation de signaux haute fréquence analogiques selon la revendication 5, **caractérisé en ce que** le signal de soustraction d'un étage de procédé est soumis à un traitement du signal (BP filter, Amp).

7. Procédé de numérisation de signaux haute fréquence analogiques selon la revendication 5 ou 6, **caractérisé en ce que** le signal de soustraction d'un n-1$^{ème}$ étage de procédé est analysé, en tant que signal d'entrée analogique quantifié d'un n$^{ème}$ étage de procédé, avec une vitesse de balayage $f_{erh}$ supérieure à la vitesse de balayage $f_a$.

8. Procédé de numérisation de signaux haute fréquence analogiques selon la revendication 6 ou 7, **caractérisé en ce que** le signal de soustraction est soumis à une correction d'amplitude et/ou de phase.

## FIG 1

analog in
X

$+$ $-$

BP Filter

A/D

digital out

Y

1    2

BP D/A    3

## FIG 2

$\cos(\omega_0 t)$

9

analog in
X

$\sin(\omega_0 t)$

9

10a    4a

$+$ $-$

LP Filter

11a    5a

$+$ $-$

LP Filter

6a

A/D

digital out

Ya

Yb

10b    4b    11b    5b    6b

LP D/A    8a

8b

LP D/A    7a

7b

# FIG 3

Stufe 2

analog in
X2

BP Filter 2.2

BP D/A
2.2

BP Filter 1.2

BP D/A
1.2

A/D

digital out
Y2

Stufe 1

analog in
X1

BP Filter 2.1

BP D/A
2.1

BP Filter 1.1

BP D/A
1.1

A/D

12

digital out
Y1

EP 1 356 592 B1

## FIG 4

analog in
X

digital out
Y

BP Filter 14

BP Filter 16

A/D 17

13

15

BP D/A 19

BP D/A 18

Signal-bearbeitung 20

BP D/A 21

Kaskadierausgang, "direkter Pfad"

Delay Verst. 23

22

analog out
Yana

# FIG 5

EP 1 356 592 B1

# FIG 6

EP 1 356 592 B1